# EUROPEAN PATENT SPECIFICATION

(11) **EP 4 191 261 B1**
(45) Date of publication and mention of the grant of the patent: **21.10.2026**
(21) Application number: 21853370.1
(22) Date of filing: 17.06.2021
(51) Int. Cl.: G01R 31/367, G01R 31/387, G01R 31/396

(54) **METHOD FOR SIMULATION OF BATTERY PACK**
VERFAHREN ZUR SIMULATION EINES BATTERIEPACKS
PROCÉDÉ DE SIMULATION DE BLOC-BATTERIE

(30) Priority: 03.08.2020 KR 20200096938
(43) Date of publication of application: 07.06.2023
(73) Proprietor: Samsung SDI Co., Ltd., Yongin-si, Gyeonggi-do 17084 (KR)
(72) Inventor: HWANG, Yong Jun, Yongin-Si Gyeonggi-do 17084 (KR); KIM, Gi Heon, Yongin-Si Gyeonggi-do 17084 (KR); PAEK, Sung Wook, Yongin-Si Gyeonggi-do 17084 (KR); KIM, Jake, Yongin-Si Gyeonggi-do 17084 (KR); RAYAPPAN, Christober, Yongin-Si Gyeonggi-do 17084 (KR); LIM, Byeonghui, Yongin-Si Gyeonggi-do 17084 (KR)
(74) Representative: Marks & Clerk LLP
(86) International application number: PCT/KR2021/007639
(87) International publication number: WO 2022/030751

(56) References cited:
- KR-A- 20140 106 436
- KR-A- 20190 032 780
- KR-A- 20190 050 169
- KR-A- 20190 123 172
- KR-A- 20190 123 172
- US-A1- 2018 095 141
- US-A1- 2018 095 141

## Description

### TECHNICAL FIELD

The disclosure relates to a method of simulating a battery pack.

### BACKGROUND ART

Compared with other energy storage devices, batteries are highly applicable and have relatively higher energy, power density, etc., and thus, have been widely applied not only to portable devices, but also to electric vehicles (EVs), hybrid electric vehicles (HEVs), or the like, driven by an electrical driving source. Particularly, when an intense output is required, a battery pack in which a plurality of batteries are serially or parallelly connected with each other may be used.

In order to use an electric device driven by a battery or a battery pack in an energy-efficient and safe manner, battery management is important. To this end, in a battery system, a device, which is a battery management system (BMS), estimates a state of the battery and according to the estimated state manages the battery or the battery pack.

The main functions of the BMS are to measure measurable physical quantities of a battery or a battery pack, such as a voltage, a current, a temperature, etc. and to estimate an internal state of the battery or the battery pack based on the previously programmed correlation between a measured values and an internal state of the battery or the battery pack. Here, state variables that are mainly measured include a state of charge (SOC) of a battery, a state of health (SoH) of a battery, a state of power capability (SoP) of a battery, etc.

Other functions of the BMS include managing the battery or the battery pack by using the estimated state. Representative ones from among these functions include a temperature management function, a cell balancing function, an abnormal cell detection function, etc. The temperature management function is a function of activating a cooling fan or inducing a decreased output of a battery pack in order to lower a temperature of the battery pack. The cell balancing function is a function of identically matching charged states of a plurality of batteries, for a battery pack, in which the plurality of batteries are serially/parallelly connected with each other, to have the ultimate performance. The abnormal cell detection function is a function of pre-emptively detecting, from a battery pack in which a plurality of batteries are serially/parallelly connected with each other, a battery cell in which abnormality occurs. The BMS may stably manage a state of the battery pack by blocking a battery cell in which abnormality occurs or informing outside of the occurrence of abnormality in the battery cell before the battery pack has a further deteriorated internal state.

To estimate an internal state of a battery or a battery pack and perform various management functions for the battery or the battery pack to maintain the utmost state, the BMS includes a state estimation algorithm and a control algorithm. The BMS may include software programs for performing the state estimation function and the management functions as described above, a sensor for measuring the measurable physical quantities, an actuator for executing actual operations, controlling hardware for controlling the actuator, etc.

In order to identify whether the BMS normally performs the state estimation function and the management functions, a method of verifying the BMS by directly connecting the BMS to an actual battery or a battery pack is used. This method may be relatively easily implemented in the case of a battery including a single cell, but to verify a BMS connected to a battery pack in which a plurality of battery cells are serially/parallelly connected with each other, time and cost may increase. Also, when, for accurate state measurement, the BMS is verified by including a plurality of sensors, which are not actually included in a battery pack, measurement may be based on state values which are not measured in the actual battery pack, and thus, normal functions of the BMS in the actual battery pack may not be guaranteed.

Moreover, in order to test the abnormal cell detection function, the operability of the function of the BMS has to be tested by actually manufacturing and measuring a battery or a battery pack including battery cells in which abnormality occurs. However, it is very difficult to artificially manufacture a battery cell in which a predetermined abnormality occurs. Even if a battery cell in which abnormality occurs is artificially manufactured and experimented, there is a danger of fire/explosion, etc., and thus, it is difficult to sufficiently verify the function of the BMS.

To solve these problems, a hardware in-the-loop simulation (HILS) method and a model-based-design (MBD) method have been developed and extensively applied, initially to the aviation/space field, with respect to which actual tests are difficult, and then to the automobile field, with respect to which a lot of expenses are required for the measurement and verification. Also, recently, a method of verifying a function of a controller, the method implementing these methods, has been broadly used in various fields.

When the HILS/MBD methods are implemented, a controller, which is difficult to actually test because of high expenses or danger, is able to be virtually realized in an actual system by using a system model capable of performing real time simulation, and then, various functions and algorithms of the controller may be effectively verified by simulating output signals of various sensors.

However, in the case of the HILS/MBD-based verification methods, the calculation speed of a central processing unit (CPU) has to be increased in proportion to the amount of calculations, in order to process a lot of calculations in real time. Also, based on the accuracy, complexity, etc. of a used model, verification of the operability of the functions and algorithms of the controller is limited. That is, when the complexity of a system model increases in order to increase the accuracy, it is difficult to simulate the real time response of a system due to an increase in the amount of calculations. KR 20190123172 A relates to a method for estimating battery status in real time.

### DESCRIPTION OF EMBODIMENTS

### TECHNICAL PROBLEM

To overcome the shortcomings of previous models, the disclosure provides a battery pack model capable of real time response processing in a low-specification device by decreasing the amount of calculations while maintaining the same degree of accuracy as the previous models, and a method of simulating a battery pack, the method using the battery pack model.

The objective of the disclosure is to provide a high speed calculation model capable of calculating, simultaneously and in real time, an internal state of a battery pack in which battery cells are serially/parallelly connected with each other.

### SOLUTION TO PROBLEM

According to an aspect of the invention, there is provided a method of simulating
a battery pack, performed by a computing device including a processor and a memory, the method including: selecting a connection relationship of battery cells included in the battery pack and an equivalent circuit model (ECM) of the battery cells; determining parameter initial values of each of the battery cells, and an initial value of a G parameter and an initial value of an H parameter of the battery pack; receiving one of a pack current value and a pack voltage value of the battery pack; based on the one of the pack current value and the pack voltage value and the initial value of the G parameter and the initial value of the H parameter of the battery pack, determining the other of the pack current value and the pack voltage value of the battery pack; based on the pack current value and the pack voltage value of the battery pack and the parameter initial values of each battery cell, determining a cell voltage value, a cell current value, and a value of a state parameter of each battery cell; based on the value of the state parameter of each battery cell, determining a value of an ECM parameter of each battery cell; based on the value of the ECM parameter of each battery cell, determining a value of a G parameter and a value of an H parameter of each battery cell; and based on the value of the G parameter and the value of the H parameter of each battery cell, determining a value of the G parameter and a value of the H parameter of the battery pack, wherein the G parameter is a parameter indicating a degree of sensitivity of voltage with respect to a change of current of the battery pack or the battery cell, and the H parameter is a parameter indicating a valid potential determined by local equilibrium potential distribution and resistance distribution in the battery pack or the battery cell.

According to another aspect of the disclosure, there is provided a computer program stored in a medium for executing the method of simulating the battery pack by using the computing device including the processor and the memory.

### ADVANTAGEOUS EFFECTS OF DISCLOSURE

A method of simulating a battery pack according to various embodiments of the disclosure has great improvements in terms of cost, expandability, and adaptiveness, compared to previous methods.

In the case of a Matlab/Simulink-based battery or battery pack model that is mainly used for the development of a previous BMS algorithm, when a serial/parallel connection relationship between battery cells is changed, the model has to be reconfigured according to the changed connection relationship, and as the number of battery cells increases, the amount of calculations exponentially increases.

However, in the case of a battery pack model provided by the disclosure, even when a serial/parallel connection relationship between battery cells is changed, a row of instructions may be simply changed, and thus, the expandability is excellent, and even when the number of battery cells increases, the amount of calculations increases only in proportion to an increase in the number of cells, and thus, a processing speed does not exponentially decrease.

In addition, the battery pack model provided by the disclosure does not have highly complex code, and thus, is able to be loaded on hardware having an 8-bit core, and hardware having an input/output (I/O) function for outputting a voltage/current signal may operate together with a virtual battery pack. Matlab/Simulink-based code previously frequently used has a large size and a low calculation speed, and thus, is not able to be applied to the hardware having a low specification, such as the 8-bit core. The battery pack model provided by the disclosure may be loaded on an embedded board and may realize a "virtual battery."

### BRIEF DESCRIPTION OF DRAWINGS

FIG. 1 is a schematic structural diagram of a computing device for performing a method of simulating a battery pack, according to an embodiment.
FIG. 2 illustrates a battery pack model performing a method of simulating a battery pack, according to an embodiment.
FIG. 3 is a flowchart of a method of simulating a battery pack, according to an embodiment.
FIG. 4 illustrates a battery pack pack including battery cells cell (1,1) through cell (m, n) which are connected with each other in a combination of a parallel manner and a serial manner.
FIG. 5 illustrates an equivalent circuit of the battery pack of FIG. 4.
FIG. 6 illustrates the second-order Thevenin's model selected as an equivalent circuit model (ECM) of a battery cell, according to the disclosure.

### BEST MODE

Advantages and characteristics of the disclosure, and a method of achieving the same will become apparent with reference to the embodiments described in detail with the accompanying drawings. However, the disclosure is not limited to the embodiments provided hereinafter. Rather, the disclosure may be realized in various different forms and shall be understood to include all changes, equivalents, or substitutes included in the concept and the technical scope of the disclosure. The embodiments described below are provided to completely disclose the disclosure so that one of ordinary skill in the art may thoroughly understand the scope of the disclosure. When describing the disclosure, well-known techniques in the art will not be described in detail, when it is determined that the detail descriptions thereof may unnecessarily blur the concept of the disclosure.

Terms used in this specification are used only for describing particular embodiments of the disclosure and are not intended to limit the disclosure. As used herein, the singular terms "a" and "an" are intended to include the plural forms as well, unless the context clearly indicates otherwise. The terms "include," "have," etc. used in this specification shall be understood to indicate the presence of a feature, a number, a step, an operation, a component, a part, or a combination thereof, described in this specification, and shall not be understood to preemptively exclude the presence or the possibility of addition of one or more other features, numbers, steps, operations, components, parts, or combinations thereof. Although the terms first, second, etc. may be used herein to describe various components, these terms do not limit the components. The terms are only used to distinguish one component from another.

Hereinafter, embodiments of the disclosure are described in detail with reference to the accompanying drawings. In the descriptions with reference to the accompanying drawings, like reference numerals refer to the like elements, and the same descriptions are not repeated.

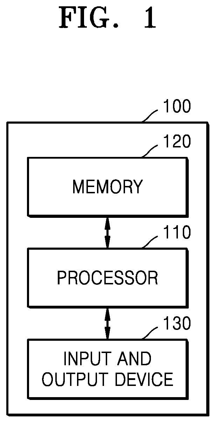

FIG. 1 is a schematic structural diagram of a computing device for performing a method of simulating a battery pack, according to an embodiment.

Referring to FIG. 1, a computing device 100 includes a processor 110, a memory 120, and an input and output device 130.

The processor 110 may perform basic arithmetic, logic, and input and output operations. For example, the processor 110 may execute program code stored in the memory 120 or read data stored in the memory 120 and use the data for the operations. The processor 110 may perform the method of simulating a battery pack, according to an embodiment.

The processor 110 may be configured to: select a connection relationship between battery cells included in the battery pack and an equivalent circuit model (ECM) of the battery cells; determine parameter initial values of each of the battery cells and a G parameter initial value and an H parameter initial value of the battery pack; receive one of a pack current value and a pack voltage value of the battery pack; based on the pack current value and the G parameter initial value and the H parameter initial value of the battery pack, determine the other of the pack current value and the pack voltage value of the battery pack; based on the pack current value and the pack voltage value of the battery pack and state parameter initial values of each of the battery cells, determine a cell voltage value, a cell current value, and a state parameter value of each of the battery cells; based on the state parameter value of each of the battery cells, determine an ECM parameter value of each of the battery cells; based on the ECM parameter value of each of the battery cells, determine a G parameter value and an H parameter value of each of the battery cells; and based on the G parameter value and the H parameter value of each of the battery cells, determine a G parameter value and an H parameter value of the battery pack.

The processor 110 may be configured to: receive one of a new pack current value and a new pack voltage value of the battery pack; based on the new pack current value and a previously determined G parameter value and a previously determined H parameter initial value of the battery pack, determine the other of the new pack current value and the new pack voltage value of the battery pack; based on the new pack current value and the new pack voltage value of the battery pack and previously determined state parameter values of each of the battery cells, determine a new cell voltage value, a new cell current value, and a new state parameter value of each of the battery cells; based on the previously determined state parameter value of each of the battery cells, determine a new ECM parameter value of each of the battery cells; based on the new ECM parameter value of each of the battery cells, determine a new G parameter value and a new H parameter value of each of the battery cells; and based on the new G parameter value and the new H parameter value of each of the battery cells, determine a new G parameter value and a new H parameter value of the battery pack.

The processor 110 may accomplish the simulation of the battery pack, by repeating the process of: receiving one of the new pack current value and the new pack voltage value; determining, based on the received value, the new cell voltage value, the new cell current value, and the new state parameter value of each of the battery cells; and determining the new G parameter value and the new H parameter value of each of the battery cells.

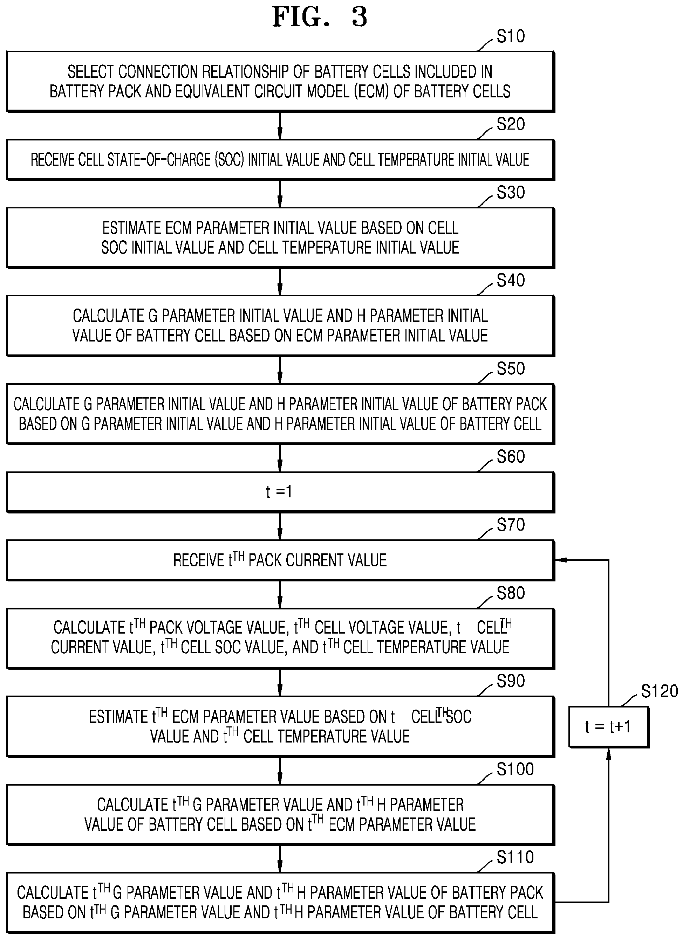

The method of simulating a battery pack is described in more detail below with reference to FIG. 3.

The memory 120 is a recording medium readable by the processor 110 of the computing device 100 and may include random access memory (RAM), read only memory (ROM), and a permanent mass storage device, such as a disk drive. An operating system and at least one program or piece of application code may be stored in the memory 120. Program code for executing the method of simulating a battery pack, according to an embodiment, may be stored in the memory 120. Also, a look-up table defining ECM parameter values, which are used in an ECM of a battery cell, based on at least one state parameter value of the battery cell, may be stored in the memory 120.

The input and output device 130 may receive an input from a user, transmit the input to the processor 110, and output information received from the processor 110 to the user. The computing device 100 may include a communication module, and the communication module may receive an input from the user, transmit the input to the processor 110, and transmit information received from the processor 110 to the user.

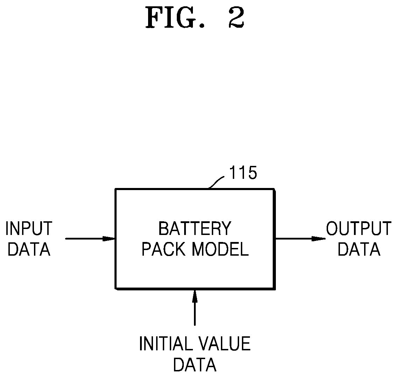

FIG. 2 illustrates a battery pack model performing a method of simulating a battery pack, according to an embodiment.

Referring to FIG. 2, a battery pack model 115 is executed by the processor 110. When the program code for executing the method of simulating a battery pack, the program code being stored in the memory 120, is executed by the processor 110, the processor 110 may operate as the battery pack model 115.

When initial value data and input data are input to the battery pack model 115, the battery pack model 115 outputs output data based on the input data. For example, the input data may be a pack current value of the battery pack, and the output data may be a voltage value of the battery pack and voltage values and current values of battery cells included in the battery pack. As another example, the input data may be a pack voltage value of the battery pack, and the output data may be a current value of the battery pack and voltage values and current values of battery cells included in the battery pack.

FIG. 3 is a flowchart of a method of simulating a battery pack, according to an embodiment.

Referring to FIG. 3, a connection relationship of battery cells included in the battery pack, and an ECM of the battery cells are selected in operation S10.

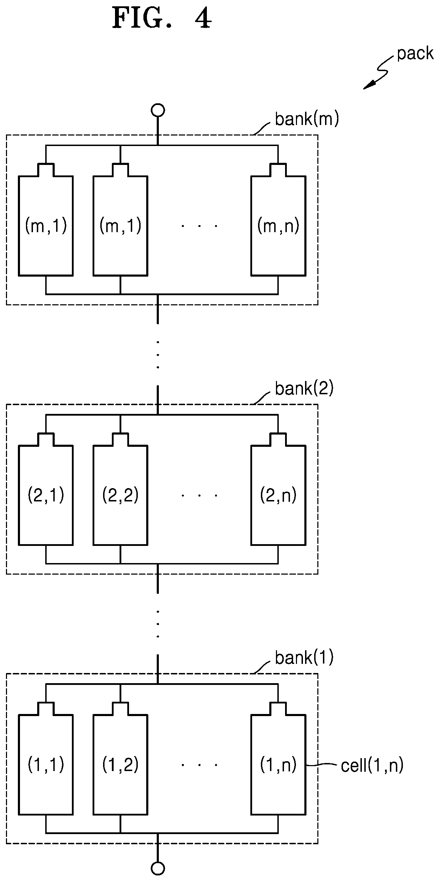

The battery pack may include the battery cells that are parallelly connected with each other, the battery cells that are serially connected with each other, or the battery cells that are parallelly and serially connected with each other. The battery pack may include the battery cells that are connected as illustrated in FIG. 4.

The battery pack includes at least one battery cell, as a portion for storing power. The battery cell may include a chargeable secondary battery. For example, the battery cell may include a nickel-cadmium battery, a lead storage battery, a nickel metal hydride (NiMH) battery, a lithium ion battery, a lithium polymer battery, etc. The number of battery cells included in the battery pack may be determined according to an output voltage and a charge capacity that are required.

FIG. 4 illustrates a battery pack pack including battery cells cell (1, 1) through cell (m, n) connected in a combination of a parallel manner and a serial manner.

Referring to FIG. 4, the battery pack pack includes m battery banks bank (1) through bank (m). A battery bank bank (i) denotes an i^{th} battery bank from among the m battery banks bank (1) through bank (m), wherein i is a natural number that is greater than or equal to 1 and less than or equal to m.

Each of the m battery banks bank (1) through bank (m) includes n battery cells cell (1, 1) through cell (1, n), ..., or cell (m, 1) through cell (m, n). A battery cell cell (i, j) denotes a j^{th} battery cell from among the n battery cells cell (i, 1) through cell (i, n) of the i^{th} battery bank bank (i), wherein j is a natural number that is greater than or equal to 1 and less than or equal to n. The battery pack pack includes the total of m x n battery cells cell (1, 1) through cell (1, n), ..., and cell (m, 1) through cell (m, n).

In this specification, an embodiment in which a battery pack includes battery cells that are connected with each other as illustrated in FIG. 4 is described. However, the battery pack pack illustrated in FIG. 4 is only an example, and the simulation method of the disclosure may be likewise applied to a battery pack including battery cells connected with each other in parallel or a battery pack including battery cells connected with each other in series.

Hereinafter, the battery cells cell (1, 1) through cell (m, n) are collectively referred to as a battery cell CELL, and the battery banks bank (1) through bank (m) are collectively referred to as a battery bank BANK.

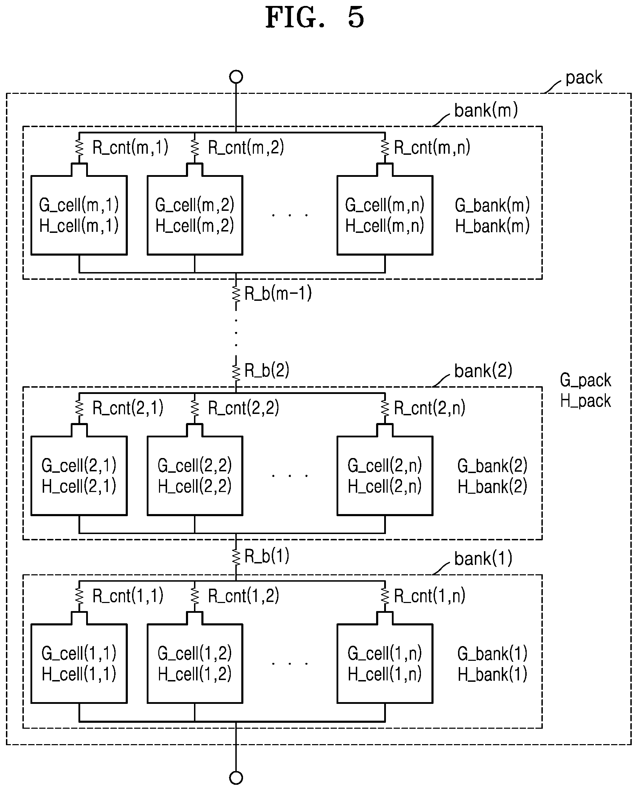

FIG. 5 illustrates an equivalent circuit of the battery pack pack of FIG. 4.

Referring to FIG. 5, an equivalent circuit of the battery pack pack includes m-1 bank resistors R_b (1) through R_b (m-1) connected in series between the m battery banks bank (1) through bank (m). The m-1 bank resistors R_b (1) through R_b (m-1) may be contact resistors between the m battery banks bank (1) through bank (m).

The equivalent circuit of the battery pack pack includes contact resistors R_cnt (1, 1) through R_cnt (1, n), ..., and R_cnt (m, 1) through R_cnt (m, n) respectively included in the m x n battery cells cell (1, 1) through cell (1, n), ..., and cell (m, 1) through cell (m, n).

Each of the battery cells cell (1, 1) through cell (1, n), ..., or cell (m, 1) through cell (m, n) has G parameters G_cell (1, 1) through G_cell (1, n), ..., or G_cell (m, 1) through G_cell (m, n) and H parameters H_cell (1, 1) through H_cell (1, n), ..., or H_cell (m, 1) through H_cell (m, n), as internal state parameters.

The battery banks bank (1) through bank (m) respectively have G parameters G_bank (1) through G_bank (m) and H parameters H_bank (1) through H_bank (m), as internal state parameters. The G parameters G_bank (1) through G_bank (m) and the H parameters H_bank (1) through H_bank (m) respectively included in the battery banks bank (1) through bank (m) may be calculated based on the G parameters G_cell (1, 1) through G_cell (1, n), ..., and G_cell (m, 1) through G_cell (m, n) and the H parameters H_cell (1, 1) through H_cell (1, n), ..., and H_cell (m, 1) through H_cell (m, n) and the contact resistors R_cnt (1, 1) through R_cnt (1, n), ..., and R_cnt (m, 1) through R_cnt (m, n) of the battery cells cell (1, 1) through cell (1_n), ..., and cell (m, 1) through cell (m, n).

The battery pack pack has a G parameter G_pack and an H parameter H_pack, as internal state parameters. The G parameter G_pack and the H parameter H_pack of the battery pack pack may be calculated based on the G parameters G_bank (1) through G_bank (m) and the H parameters H_bank (1) through H_bank (m) respectively included in the battery banks bank (1) through bank (m), and the m-1 bank resistors R_b (1) through R_b (m-1).

The G parameter G is a state quantity indicating a degree of sensitivity of voltage with respect to a change of current of a battery and has units of resistance. The H parameter H is a valid potential determined by local equilibrium potential distribution and resistance distribution in a battery and has units of voltage. A battery may refer to a battery cell CELL, a battery bank BANK, or a battery pack pack.

The G parameter G and the H parameter H of the battery may be quantized by an explicit correlation formula of a battery material property and design variables by using a theoretical model. Hereinafter, the G parameter G and the H parameter H of the battery are described.

With respect to a battery, it may be assumed that voltage V and current i have, for example, a relationship of V=f (i; x, p). Here, x is a physical quantity indicating an internal state of the battery, and p is a parameter.

A function f is a nonlinear implicit function, and when the function f is able to be divided into a quantity g rapidly changing and a quantity h slowly changing, the correlation formula above may be represented as V=g (i; x, p) + h (i; x, p).

When it is assumed that there is a function of G (i; x, p) = dg/di slowly changing with respect to the current i, the above correlation formula may be represented as V=G (i; x, p) i + H (i; x, p).

In the above correlation formula, dG/di and dH/di have very small values. In other words, when the described assumptions are satisfied, G and H are functions slowly changing with respect to the current i, and thus, the function f indicating a nonlinear relationship of the voltage V and the current i may be represented by a quasi-linear relationship as the correlation formula described above.

Here, G is referred to as the G parameter and H is referred to as the H parameter. When the current i is a charge and discharge current, and Ueq is an equilibrium potential of the battery, a discharge overvoltage may be represented by Ueq - V = -G · i + (Ueq - H) by using the G parameter G and the H parameter H.

Here, -G · i is an overvoltage generated for a current leakage of the battery through a terminal and includes a reaction dynamic polarization amount and an electron and ion resistance polarization amount . (Ueq - H) is an overvoltage generated because a local thermodynamic equilibrium state of the battery deviates from an equilibrium state of a general system. That is, (Ueq - H) indicates the inefficiency occurring due to thermodynamic non-uniformity in the battery, and when an internal system of the battery reaches the thermodynamic equilibrium state, the H parameter H becomes equal to the equilibrium potential Ueq.

According to the method of simulating a battery pack, according to embodiments of the disclosure, a state of the battery pack pack is relatively more simply simulated, by calculating and using the G parameter G and the H parameter H of each of the battery cell CELL, the battery bank BANK, and the battery pack pack.

Referring to FIG. 3 again, an ECM of the battery cells may be selected. For example, as the ECM, an internal resistance battery model, a first-order Thevenin's model, a second-order Thevenin's model, an n^{th} Thevenin's model (n is a natural number greater than or equal to 3), etc. may be selected.

According to the internal resistance battery model, the battery cell CELL may be modeled by a voltage source having an open circuit voltage value and a series resistor. According to the first-order Thevenin's model, the battery cell CELL may be modeled by a voltage source having an open circuit voltage value, a series resistor, and a first parallel resistor and a first parallel capacitor that are parallelly connected with each other.

According to the second-order Thevenin's model, the battery cell CELL may be modeled by a voltage source having an open circuit voltage value, a series resistor, a first parallel resistor and a first parallel capacitor that are parallelly connected with each other, and a second parallel resistor and a second parallel capacitor that are parallelly connected with each other.

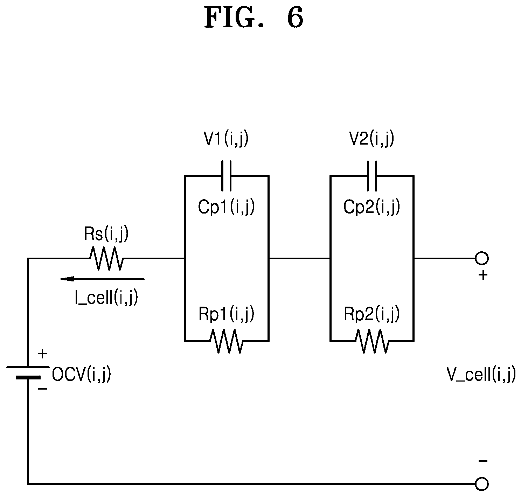

FIG. 6 illustrates the second-order Thevenin's model selected as an ECM of the battery cell, according to the disclosure.

Referring to FIG. 6, a battery cell cell (i, j) may be modeled by a voltage source having an open circuit voltage value OCV (i, j), a series resistor Rs (i, j), a first parallel resistor Rp1 (i, j) and a first parallel capacitor Cp1 (i, j) that are parallelly connected with each other, and a second parallel resistor Rp2 (i, j) and a second parallel capacitor Cp2 (i, j) that are parallelly connected with each other.

A cell voltage of the battery cell cell (i, j) is V_cell (i, j) and a cell current thereof is I_cell (i, j). A voltage of the first parallel resistor Rp1 (i, j) and the first parallel capacitor Cp1 (i, j) is indicated as a first voltage V1 (i, j), and a voltage of the second parallel resistor Rp2 (i, j) and the second parallel capacitor Cp2 (i, j) is indicated as a second voltage V2 (i, j). V_cell (i, j) is equal to OCV (i, j) + V1 (i, j) + V2 (i, j). The cell current I_cell (i, j) may be defined as having a positive (+) value during charging and a negative (-) value during discharging.

In this specification, embodiments in which the second-order Thevenin's model is selected as the ECM of the battery cell are described. However, the method of simulating a battery pack, according to the disclosure, may also be applied to a case in which other ECMs are selected, except for the second-order Thevenin's model.

Referring to FIG. 3 again, parameter initial values of each of the battery cells, and a G parameter initial value G_pack [0] and an H parameter initial value G_pack [0] of the battery pack pack are determined.

According to an embodiment, the parameter initial values of each battery cell may include a state parameter initial value of each battery cell and ECM parameter initial values of each battery cell.

According to an embodiment, the state parameter initial value of each battery cell may include a cell state-of-charge (SOC) initial value of each battery cell. Also, the state parameter initial value of each battery cell may further include a cell temperature initial value of each battery cell.

In this specification, an embodiment in which a state parameter of each battery cell includes a cell SOC and a cell temperature of each battery cell is described. However, the disclosure is not limited thereto, and the state parameter may include only the cell SOC or may further include other parameters in addition to the cell SOC and the cell temperature.

According to an embodiment, the state parameter initial value of each battery cell may be received. For example, a cell SOC initial value SOC_cell [0] and a cell temperature initial value T_cell [0] of each battery cell may be received in operation S20. For example, with respect to all of the battery cells, a cell SOC initial value SOC_cell (i, j) [0] and a cell temperature initial value T_cell (i, j) [0] of a battery cell cell (i, j) may be received.

In this specification, an initial value is indicated as "[0]." Input data is a set of input values having a predetermined time interval. Output data is also a set of output values having a predetermined time interval. Values that are input or output at a first timing are indicated as "[1]," and values that are input or output at a second timing are indicated as "[2]." For example, the predetermined time interval may be the same as a sampling period for measuring a pack voltage or a pack current. The predetermined time interval may be indicated as "Δt." When the first timing is t0, the second timing may be t0+Δt.

According to an embodiment, other parameter values used in the simulation method according to the disclosure may be received. For example, a bank resistance value R_b (i) of each of the battery banks and a contact resistance value R_cnt (i, j) of each of the battery cells may be received. Also, the total capacity Qtotal_cell (i, j) of each battery cell may be received. In addition, information about a cell mass (design mass (DM)), a cell specific heat Cpk, and a surface area (design area (DA)) of the battery cells may be received. Also, information about a convective heat transfer coefficient h with external air and external air temperature T_amb may be received. Also, information about the time interval Δt of input values of the input data may be received or predetermined.

The ECM parameter initial values of each battery cell may be determined based on the state parameter initial value of each battery cell. According to an embodiment, based on the cell SOC initial value SOC_cell [0] and the cell temperature initial value T_cell [0] of each battery cell, the ECM parameter initial values of each battery cell may be estimated in operation S30.

In this specification, the second-order Thevenin's model is used as the ECM, and thus, ECM parameters may include an open circuit voltage value OCV, a series resistance value Rs, a first parallel resistance value Rp1, a first parallel capacitance value Cp1, a second parallel resistance value Rp2, and a second parallel capacitance value Cp2.

In order to estimate the ECM parameter initial values of each battery cell, a look-up table in which ECM parameter values are defined according to a state parameter value of each battery cell may be stored in the memory 120. According to an embodiment, the look-up table may store the ECM parameter values, that is, the open circuit voltage value OCV, the series resistance value Rs, the first parallel resistance value Rp1, the first parallel capacitance value Cp1, the second parallel resistance value Rp2, and the second parallel capacitance value Cp2, according to the cell SOC value SOC_cell and the cell temperature value T_cell of each battery cell.

According to an embodiment, an open circuit voltage initial value OCV [0], a series resistance initial value Rs [0], a first parallel resistance initial value Rp1 [0], a first parallel capacitance initial value Cp1 [0], a second parallel resistance initial value Rp2 [0], and a second parallel capacitance initial value Cp2 [0] of each battery cell may be estimated according to the cell SOC initial value SOC_cell [0] and the cell temperature initial value T_cell [0] of each battery cell, by referring to the look-up table stored in the memory 120. Therefore, with respect to all of the battery cells, the open circuit voltage initial value OCV (i, j) [0], the series resistance initial value Rs (i, j) [0], the first parallel resistance initial value Rp1 (i, j) [0], the first parallel capacitance initial value Cp1 (i, j) [0], the second parallel resistance initial value Rp2 (i, j) [0], and the second parallel capacitance initial value Cp2 (i, j) [0] of the battery cell cell (i, j) may be determined.

Based on the ECM parameter initial values of each battery cell, a G parameter initial value G_cell [0] and an H parameter initial value H_cell [0] of each battery cell may be determined in operation S40.

With respect to all battery cells, the G parameter initial value G_cell (i, j) [0] of the battery cell cell (i, j) may be determined to be the series resistance initial value Rs (i, j) [0] of the battery cell cell (i, j), and the H parameter initial value H_cell (i, j) [0] of the battery cell cell (i, j) may be determined to be the open circuit voltage initial value OCV (i, j) [0] of the battery cell cell (i, j).

Based on the G parameter initial value G_cell [0] and the H parameter initial value H_cell [0] of each battery cell, a G parameter initial value G_pack [0] and an H parameter initial value H_pack [0] of the battery pack pack may be determined in operation S50.

According to an embodiment, based on the G parameter initial value G_cell [0], the H parameter initial value H_cell [0], and the contact resistance value R_cnt of each battery cell, a G parameter initial value G_bank [0] and an H parameter initial value H_bank [0] of each of the battery banks may be determined.

For example, the G parameter initial value G_bank [0] of each battery bank may be calculated by the following equation based on the G parameter initial value G_cell [0] and the contact resistance value R_cnt of each battery cell. $G_bank \left(i\right) = \frac{1}{{\sum }_{j = 1}^{n} \frac{1}{G_cell \left(i, j\right) + R_cnt \left(i, j\right)}}$

For example, the H parameter initial value H_bank [0] of each battery bank may be calculated by the following equation based on the G parameter initial value G_cell [0], the H parameter initial value H_cell [0], and the contact resistance value R_cnt of each battery cell. $H_bank \left(i\right) = \frac{{\sum }_{j = 1}^{n} \frac{H_cell \left(i, j\right)}{G_cell \left(i, j\right) + R_cnt \left(i, j\right)}}{{\sum }_{j = 1}^{n} \frac{1}{G_cell \left(i, j\right) + R_cnt \left(i, j\right)}}$

The above equations may be derived by using the relationship that a bank current I_bank (i) flowing in the i^{th} battery bank bank (i) is the same as a sum of cell currents I_cell (i, 1) through I_cell (i, n) respectively flowing in the n battery cells cell (i, 1) through cell (i, n) included in the i^{th} battery bank bank (i), the relationship that a bank voltage V_bank (i) of the i^{th} battery bank bank (i) is the same as a value obtained by adding, to cell voltages V_cell (i, 1) through V_cell (i, n) respectively corresponding to the n battery cells cell (i, 1) through cell (i, n), a value obtained by multiplying the contact resistance R_cnt (i, j) by the cell currents I_cell (i, 1) through I_cell (i, n), and the relationship of V_bank (i) = H_bank (i) + G_bank (i) * I_bank (i).

According to an embodiment, based on the G parameter initial value G_bank [0] and the H parameter initial value H_bank [0] of each battery bank, and the m-1 bank resistance values R_b, the G parameter initial value G_pack [0] and the H parameter initial value H_pack [0] of the battery pack pack may be determined.

For example, the G parameter initial value G_pack [0] of the battery pack pack may be calculated by the following equation based on the G parameter initial value G_bank [0] of each battery bank and the m-1 bank resistance values R_b. $G_pack = {\sum }_{i = 1}^{m} G_bank \left(i\right) + {\sum }_{i = 1}^{m - 1} R_b \left(i\right)$

For example, the H parameter initial value H_pack [0] of the battery pack pack may be calculated by the following equation based on the H parameter initial value H_bank [0] of each battery bank. $H_pack = {\sum }_{i = 1}^{m} H_bank \left(i\right)$

The above equations may be derived by using the relationship that a pack current I_pack flowing in the battery pack pack is the same as the bank current I_bank (i) flowing in the battery bank bank (i) connected in series, the relationship that a pack voltage V_pack of the battery pack pack is the same as a value obtained by adding, to a sum of bank voltages V_bank of the battery banks, a value obtained by multiplying the bank resistances R_b by the pack current I_pack, and the relationship of V_pack = H_pack + G_pack * I_pack.

Through the above operations S10 through S50, initial configuration of the battery pack model 115 may be completed. Thereafter, a simulation operation of the battery pack model 115 according to input data is described.

First, in order to indicate an order of input values having a predetermined time interval, 1 may be input as a time variable t in operation S60. Values corresponding to t=1 may be indicated as "[1]."

As the input data, one of the pack current value I_pack [1] and the pack voltage value V_pack [1] of the battery pack pack may be received.

Based on the one of the pack current value I_pack [1] and the pack voltage value V_pack [1] of the battery pack pack, and the G parameter initial value G_pack [0] and the H parameter initial value H_pack [0] of the battery pack pack, the other of the pack current value I_pack [1] and the pack voltage value V_pack [1] of the battery pack pack may be determined. For example, when the pack current value I_pack [1] is received, the pack voltage value V_pack [1] may be calculated, and when the pack voltage value V_pack [1] is received, the pack current value I_pack [1] may be calculated, by using the correlation formula of V_pack [1] = H_pack [0] + G_pack [0] * I_pack [1].

In this specification, an embodiment in which the pack current value I_pack [1] of the battery pack pack is received, is described. However, the disclosure is not limited thereto and may be likewise applied to a case in which the pack voltage value V_pack [1] of the battery pack pack is received.

According to an embodiment, the pack current value I_pack [1] of the battery pack pack may be received in operation S70. Based on the pack current value I_pack [1] of the battery pack pack and the initial values received or determined in operations S20 through S50, the pack voltage value V_pack [1] of the battery pack pack, the cell voltage value V_cell [1], the cell current value I_cell [1], the cell SOC value SOC_cell [1], and the cell temperature value T_cell [1] of each battery cell may be calculated in operation S80.

The pack voltage value V_pack [1] of the battery pack pack may be calculated by using the correlation formula of V_pack [1] = H_pack [0] + G_pack [0] * I_pack [1] based on the pack current value I_pack [1] of the battery pack pack, and the G parameter initial value G_pack [0] and the H parameter initial value H_pack [0] of the battery pack pack.

According to an embodiment, based on the pack current value I_pack [1] of the battery pack pack and the G parameter initial value G_bank [0] and the H parameter initial value H_bank [0] of each battery bank, a bank voltage value V_bank [1] and a bank current value I_bank [1] of each battery bank may be calculated. For example, with respect to all of the battery banks, the bank current value I_bank (i) [1] of the battery bank bank (i) may be the same as the pack current value I_pack [1]. With respect to all battery banks, the bank voltage value V_bank (i) [1] of the battery bank bank (i) may be calculated by using the correlation formula of V_bank (i) [1] = H_bank (i) [0] + G_bank (i) [0] * I_bank (i) [1].

According to another embodiment, the bank voltage value V_bank [1] of the battery bank bank (i) may be calculated by using repeated calculations. For example, with respect to V_bank (i) [0 + (k)] = H_bank (i) [0 + (k - 1)] + G_bank (i) [0 + (k - 1)] * I_bank (i) [1], V_bank (i) [0 + (k)] may be calculated by increasing k by 1 from 1. Here, when a difference between V_bank (i) [0 + (k)] and V_bank (i) [0 + (k - 1)] is less than or equal to a predetermined reference value, the bank voltage value V_bank [1] may be determined to be V_bank (i) [0 + (k)]. H_bank (i) [0 + (k)] and G_bank (i) [0 + (k)] may also be calculated through repeated calculations, and the process of calculation may be easily understood from the following description.

According to an embodiment, based on the bank voltage value V_bank [1] of each battery bank, and the G parameter initial value G_cell [0], the H parameter initial value H_cell [0], and the contact resistance value R_cnt of each battery cell, the cell current value I_cell [1] of each battery cell may be calculated. For example, with respect to all battery cells, the cell current value I_cell (i, j) [1] of the battery cell cell (i, j) may be calculated by using the correlation formula of I_cell (i, j) [1] = {V_bank (i) [1] - H_cell (i, j) [0]} / {G_cell (i, j) [0] + R_cnt (i, j)}.

According to another embodiment, the cell current value I_cell (i, j) [1] of the battery cell cell (i, j) may be calculated through repeated calculations. For example, with respect to I_cell (i, j) [0 + (k)] = {V_bank (i) [0 + (k)] - H_cell (i, j) [0 + (k - 1)]} / {G_cell (i, j) [0 + (k - 1)] + R_cnt (i, j)}, I_cell (i, j) [0 + (k)] may be calculated by increasing k by 1 from 1. Here, when a difference between I_cell (i, j) [0 + (k)] and I_cell (i, j) [0 + (k - 1)] is less than or equal to a predetermined reference value, the cell current value I_cell (i, j) [1] may be determined to be I_cell (i, j) [0 + (k)]. H_cell (i, j) [0 + (k)] and G_cell (i, j) [0 + (k)] may also be calculated through repeated calculations, and the process of calculation may be easily understood from the following description.

According to an embodiment, based on the bank voltage value V_bank [1] of each battery bank, and the cell current I_cell [1] and the contact resistance value R_cnt of each battery cell, the cell voltage value V_cell [1] of each battery cell may be calculated. For example, with respect to all battery cells, the cell voltage value V_cell (i, j) [1] of the battery cell cell (i, j) may be calculated by using the correlation formula of V_cell (i, j) [1] = {V_bank (i) [1] + R_cnt (i, j) * I_cell (i, j) [0].

According to another embodiment, the cell voltage value V_cell (i, j) [1] of the battery cell cell (i, j) may be calculated through repeated calculations. For example, with respect to V_cell (i, j) [0 + (k)] = V_bank (i) [0 + (k)] + R_cnt (i, j) * I_cell (i, j) [0 + (k)], V_cell (i, j) [0 + (k)] may be calculated by increasing k by 1 from 1. Here, when a difference between V_cell (i, j) [0 + (k)] and V_cell (i, j) [0 + (k - 1)] is less than or equal to a predetermined reference value, the cell voltage value V_cell (i, j) [1] may be determined to be V_cell (i, j) [0 + (k)].

According to an embodiment, based on the cell SOC initial value SOC_cell [0] and the cell current value I_cell [1] of each battery cell, the total capacity Qtotal_cell, and the time interval Δt, the cell SOC value SOC_cell [1] of each battery cell may be calculated. For example, with respect to all battery cells, the cell SOC value SOC_cell (i, j) [1] of the battery cell cell (i, j) may be calculated by using the correlation formula of SOC_cell (i, j) [1] = SOC_cell (i, j) [0] + I_cell (i, j) [1] * Δt / Qtotal_cell (i, j).

According to an embodiment, based on the cell temperature initial value T_cell [0], the cell current value I_cell [1], the series resistance initial value Rs [0], and the first parallel resistance initial value Rp1 [0], and the second parallel resistance initial value Rp2 [0] of each battery cell, and the time interval Δt, the cell temperature value T_cell [1] of each battery cell may be calculated. For example, with respect to all battery cells, the cell temperature value T_cell (i, j) [1] of the battery cell cell (i, j) may be calculated by using the correlation formula of T_cell (i, j) [1] = T_cell (i, j) [0] + Δt * {I_cell (i, j) [1]² * (Rs (i, j) [0] + Rp1 (i, j) [0] + Rp2 (i, j) [0]) - h * DA * (T_cell (i, j) [0] - T_amb)} / (DM * Cpk) . Here, DM indicates a mass of the battery cell cell (i, j), Cpk indicates a specific heat of the battery cell cell (i, j), DA indicates a surface area of the battery cell (i, j), h indicates a convective heat transfer coefficient with external air, and T_amb indicates a temperature of external air (for example, room temperature).

The ECM parameter value of each battery cell may be determined based on the state parameter value of each battery cell.

According to an embodiment, based on the cell SOC value SOC_cell [1] and the cell temperature value T_cell [1] of each battery cell, the ECM parameter values of each battery cell may be estimated in operation S90. As described above, the memory 120 may store the look-up table in which the ECM parameter values, that is, the open circuit voltage value OCV, the series resistance value Rs, the first parallel resistance value Rp1, the first parallel capacitance value Cp1, the second parallel resistance value Rp2, and the second parallel capacitance value Cp2, are defined according to the cell SOC value SOC_cell and the cell temperature value T_cell of each battery cell.

According to an embodiment, an open circuit voltage value OCV [1], a series resistance value Rs [1], a first parallel resistance value Rp1 [1], a first parallel capacitance value Cp1 [1], a second parallel resistance value Rp2 [1], and a second parallel capacitance value Cp2 [1] of each battery cell may be estimated according to the cell SOC value SOC_cell [1] and the cell temperature initial value T_cell [0] of each battery cell, by referring to the look-up table stored in the memory 120. Therefore, with respect to all battery cells, the open circuit voltage value OCV (i, j) [1], the series resistance value Rs (i, j) [1], the first parallel resistance value Rp1 (i, j) [1], the first parallel capacitance value Cp1 (i, j) [1], the second parallel resistance value Rp2 (i, j) [1], and the second parallel capacitance value Cp2 (i, j) [1] of the battery cell cell (i, j) may be determined, based on the cell SOC value SOC_cell (i, j) [1] and the cell temperature initial value T_cell (i, j) [0], by referring to the look-up table stored in the memory 120.

Based on the ECM parameter value of each battery cell, a G parameter value G_cell [1] and an H parameter value H_cell [1] of each battery cell may be determined.

According to an embodiment, based on the open circuit voltage value OCV [1], the series resistance value Rs [1], the first parallel resistance value Rp1 [1], the first parallel capacitance value Cp1 [1], the second parallel resistance value Rp2 [1], and the second parallel capacitance value Cp2 [1] of each battery cell, the G parameter value G_cell [1] and the H parameter value H_cell [1] of each battery cell may be calculated.

With respect to all battery cells, the G parameter value G_cell (i, j) [1] of the battery cell cell (i, j) may be determined to be the series resistance value Rs (i, j) [1] of the battery cell cell (i, j). That is, the G parameter value G_cell (i, j) [1] of the battery cell cell (i, j) may be calculated as G_cell (i, j) [1] = Rs (i, j) [1].

According to another embodiment, the G parameter value G_cell (i, j) [1] of the battery cell cell (i, j) may be calculated through repeated calculations. For example, with respect to G_cell (i, j) [0 + (k)] = Rs (i, j) [0 + (k)], G_cell (i, j) [0 + (k)] may be calculated by increasing k by 1 from 1. Here, when a difference between G_cell (i, j) [0 + (k)] and G_cell (i, j) [0 + (k - 1)] is less than or equal to a predetermined reference value, the G parameter value G_cell (i, j) [1] may be determined to be G_cell (i, j) [0 + (k)].

With respect to all battery cells, the H parameter value H_cell (i, j) [1] of the battery cell cell (i, j) may be determined based on the open circuit voltage value OCV (i, j) [1], a first voltage value V1 (i, j) [1], and a second voltage value V2 (i, j) [1] of the battery cell cell (i, j). As illustrated in FIG. 6, the first voltage value V1 (i, j) [1] may be a voltage value of the first parallel resistor Rp1 (i, j) [1] and the first parallel capacitor Cp1 (i, j) [1] that are parallelly connected with each other, and the second voltage value V2 (i, j) [1] may be a voltage value of the second parallel resistor Rp2 (i, j) [1] and the second parallel capacitor Cp2 (i, j) [1] that are parallelly connected with each other.

For example, with respect to all battery cells, the H parameter value H_cell (i, j) [1] of the battery cell cell (i, j) may be determined to be a value obtained by subtracting the first voltage value V1 (i, j) [1] and the second voltage value V2 (i, j) [1] from the open circuit voltage value OCV (i, j) [1] of the battery cell cell (i, j). That is, the H parameter value H_cell (i, j) [1] of the battery cell cell (i, j) may be calculated as H_cell (i, j) [1] = OCV (i, j) [1] + V1 (i, j) [1] + V2 (i, j) [1].

The first voltage value V1 (i, j) [1] of the battery cell cell (i, j) may be calculated as V1 (i, j) [1] = (V1 (i, j) [0] * exp (-Δt / τ1 (i, j) [1]) + Rp1 (i, j) [1] * (1 - exp (-Δt / τ1 (i, j) [1])) * I_cell (i, j) [1]). Here, τ1 (i, j) [1] is defined as Rp1 (i, j) [1] * Cp1 (i, j) [1].

The second voltage value V2 (i, j) [1] of the battery cell cell (i, j) may be calculated as V2 (i, j) [1] = (V2 (i, j) [0] * exp (-Δt / τ2 (i, j) [1]) + Rp2 (i, j) [1] * (1 - exp (-Δt / τ2 (i, j) [1])) * I_cell (i, j) [1]). Here, τ2 (i, j) [1] is defined as Rp2 (i, j) [1] * Cp2 (i, j) [1].

According to another embodiment, the H parameter value H_cell (i, j) [1] of the battery cell cell (i, j) may be calculated through repeated calculations. For example, with respect to H_cell (i, j) [0 + (k)] = OCV (i, j) [0 + (k)] + V1 (i, j) [0 + (k)] + V2 (i, j) [0 + (k)] = OCV (i, j) [0 + (k)] + {(V1 (i, j) [0 + (k - 1)] * exp (-Δt / τ1 (i, j) [0 + (k)]) + Rp1 (i, j) [0 + (k)] * (1 - exp (-Δt / τ1 (i, j) [0 + (k)])) * I_cell (i, j) [0 + (k)])} + {(V2 (i, j) [0 + (k - 1)] * exp (-Δt / τ2 (i, j) [0 + (k)]) + Rp2 (i, j) [0 + (k)] * (1 - exp (-Δt / τ2 (i, j) [0 + (k)])) * I_cell (i, j) [0 + (k)])} (here, τ1 (i, j) [0 + (k)] = Rp1 (i, j) [0 + (k)] * Cp1 (i, j) [0 + (k)], τ2 (i, j) [0 + (k)] = Rp2 (i, j) [0 + (k)] * Cp2 (i, j) [0 + (k)]), H_cell (i, j) [0+(k)] may be calculated by increasing k by 1 from 1. Here, when a difference between H_cell (i, j) [0 + (k)] and H_cell (i, j) [0 + (k - 1)] is less than or equal to a predetermined reference value, the H parameter value H_cell (i, j) [1] may be determined to be H_cell (i, j) [0 + (k)].

Based on the G parameter value G_cell [1] and the H parameter value H_cell [1] of each battery cell, a G parameter value G_pack [1] and an H parameter value H_pack [1] of the battery pack pack may be determined in operation S110.

According to an embodiment, based on the G parameter value G_cell [1], the H parameter value H_cell [1], and the contact resistance value R_cnt of each battery cell, the G parameter value G_bank [1] and the H parameter value H_bank [1] of each battery bank may be determined.

For example, the G parameter value G_bank (i) [1] of the i^{th} battery bank bank (i) may be calculated by the following equation based on the G parameter values G_cell (i, 1) [1] through G_cell (i, n) [1] and the contact resistance values R_cnt (i, 1) through R_cnt (i, n) respectively included in the n battery cells cell (i, 1) through cell (i, n) included in the i^{th} battery bank bank (i). $G_bank \left(i\right) = \frac{1}{{\sum }_{j = 1}^{n} \frac{1}{G_cell \left(i, j\right) + R_cnt \left(i, j\right)}}$

For example, the H parameter initial value H_bank (i) [0] of the i^{th} battery bank bank (i) may be calculated by the following equation based on the G parameter values G_cell (i, 1) [1] through G_cell (i, n) [1], the H parameter values H_cell (i, 1) [1] through H_cell (i, n) [1]), and the contact resistance values R_cnt (i, 1) through R_cnt (i, n) respectively included in the n battery cells cell (i, 1) through cell (i, n) included in the i^{th} battery bank bank (i). $H_bank \left(i\right) = \frac{{\sum }_{j = 1}^{n} \frac{H_cell \left(i, j\right)}{G_cell \left(i, j\right) + R_cnt \left(i, j\right)}}{{\sum }_{j = 1}^{n} \frac{1}{G_cell \left(i, j\right) + R_cnt \left(i, j\right)}}$

The above equations may be derived by using the relationship that the bank current I_bank (i) flowing in the i^{th} battery bank bank (i) is the same as the sum of the cell currents I_cell (i, 1) through I_cell (i, n) respectively flowing in the n battery cells cell (i, 1) through cell (i, n) included in the i^{th} battery bank bank (i), the relationship that the bank voltage V_bank (i) of the i^{th} battery bank bank (i) is the same as the value obtained by adding, to the cell voltages V_cell (i, 1) through V_cell (i, n) respectively corresponding to the n battery cells cell (i, 1) through cell (i, n), the value obtained by multiplying the contact resistance R_cnt (i, j) by the cell currents I_cell (i, 1) through I_cell (i, n), and the relationship of V_bank (i) = H_bank (i) + G_bank (i) * I_bank (i).

According to an embodiment, the G parameter value G_pack [1] and the H parameter value H_pack [1] of the battery pack pack may be determined based on the G parameter value G_bank [1] and the H parameter value H_bank [1] of each battery bank, and the m-1 bank resistance values R_b.

For example, the G parameter value G_pack [1] of the battery pack pack may be calculated by the following equation based on the G parameter values G_bank (1) [1] through G_bank (m) [1]) respectively included in the battery banks and the m-1 bank resistance values R_b (1) through R_n (m-1). $G_pack = {\sum }_{i = 1}^{m} G_bank \left(i\right) + {\sum }_{i = 1}^{m - 1} R_b \left(i\right)$

For example, the H parameter value H_pack [1] of the battery pack pack may be calculated by the following equation based on the H parameter values H_bank (1) [1] through H_bank (m) [1] respectively included in the battery banks. $H_pack = {\sum }_{i = 1}^{m} H_bank \left(i\right)$

The above equations may be derived by using the relationship that the pack current I_pack flowing in the battery pack pack is the same as the bank current I_bank (i) flowing in the battery bank bank (i) connected in series, the relationship that the pack voltage V_pack of the battery pack pack is the same as the value obtained by adding, to the sum of the bank voltages V_bank of the battery banks, the value obtained by multiplying the bank resistances R_b by the pack current I_pack, and the relationship of V_pack = H_pack + G_pack * I_pack.

As described above, based on the pack current value I_pack [1] received in operation S70, the pack voltage value V_pack [1] and the cell voltage value V_cell [1], the cell current value I_cell [1], the cell SOC value SOC_cell [1], and the cell temperature value T_cell [1] of each battery cell may be calculated in operation S80, and the G parameter value G_cell [1] and the H parameter value H_cell [1] of each battery cell, and the G parameter value G_pack [1] and the H parameter value H_pack [1] of the battery pack pack may be updated in operations S90 through S110. Thereafter, the calculation may proceed to operation S120, and t may increase by 1.

In operation S70, a pack current value I_pack [2] may be received, and based on the pack current value I_pack [2], a pack voltage value V_pack [2], and a cell voltage value V_cell [2], a cell current value I_cell [2], a cell SOC value SOC_cell [2], and a cell temperature value T_cell [2] of each battery cell may be calculated in operation S80, and a G parameter value G_cell [2] and an H parameter value H_cell [2] of each battery cell, and a G parameter value G_pack [2] and an H parameter value H_pack [2] of the battery pack pack may be updated in operations S90 through S110. Thereafter, the calculation may proceed to operation S120, and t may increase by 1.

Through this process, based on the input data including the pack current values, the battery pack model 115 may accurately and quickly simulate a state change of each battery cell and a state change of the battery pack pack.

According to the simulation method according to the disclosure, calculation may be highly rapidly performed. As a result of performing the simulation of a battery pack in which ten battery cells are connected with each other in series, based on a method according to the disclosure and on a Simulink-based method according to the related art, the method according to the disclosure completed the calculation within five seconds on average, but the Simulink-based method according to the related art took forty minutes or more to complete the calculation. In this experiment, the time interval Δt was 0.01 seconds, and the simulation was performed based on a scenario in which the battery was discharged once and charged once, and the execution time was 60 minutes in total. The method according to the disclosure showed an improvement in calculation speed mounting to 520 times higher than the previous method.

Also, in the case of the method according to the disclosure, when the number of battery cells increased, the operation time increased proportionately to the number of battery cells. However, in the case of the previous method, the operation time increased exponentially with respect to the battery cells. Therefore, as the number of battery cells increases, the method according to the disclosure has a higher speed improvement effect than the previous method.

## Claims

1. A method of simulating a battery pack, performed by a computing device (100) including a processor (110) and a memory (120), the method comprising:
selecting a connection relationship of battery cells included in the battery pack and an equivalent circuit model, ECM, of the battery cells;
determining parameter initial values of each of the battery cells, and an initial value of a G parameter and an initial value of an H parameter of the battery pack;
receiving one of a pack current value and a pack voltage value of the battery pack;
based on the one of the pack current value and the pack voltage value and the initial value of the G parameter and the initial value of the H parameter of the battery pack, determining the other of the pack current value and the pack voltage value of the battery pack;
based on the pack current value and the pack voltage value of the battery pack and the parameter initial values of each battery cell, determining a cell voltage value, a cell current value, and a value of a state parameter of each battery cell;
based on the value of the state parameter of each battery cell, determining a value of an ECM parameter of each battery cell;
based on the value of the ECM parameter of each battery cell, determining a value of a G parameter and a value of an H parameter of each battery cell; and
based on the value of the G parameter and the value of the H parameter of each battery cell, determining a value of the G parameter and a value of the H parameter of the battery pack,
wherein the G parameter is a parameter indicating a degree of sensitivity of voltage with respect to a change of current of the battery pack or the battery cell, and
the H parameter is a parameter indicating a valid potential determined by local equilibrium potential distribution and resistance distribution in the battery pack or the battery cell.

2. The method of simulating the battery pack of claim 1, wherein the determining of the parameter initial values of each of the battery cells, and the initial value of the G parameter and the initial value of the H parameter of the battery pack includes:
receiving an initial value of the state parameter of each battery cell;
based on the initial value of the state parameter of each battery cell, determining initial values of the ECM parameter of each battery cell;
based on the initial values of the ECM parameter of each battery cell, determining an initial value of the G parameter and an initial value of the H parameter of each battery cell; and
based on the initial value of the G parameter and the initial value of the H parameter of each battery cell, determining the initial value of the G parameter and the initial value of the H parameter of the battery pack.

3. The method of simulating the battery pack of claim 1, wherein the state parameter of each battery cell includes a cell state-of-charge (SOC) of each battery cell.

4. The method of simulating the battery pack of claim 1, wherein the state parameter of each battery cell further includes a temperature of each battery cell.

5. The method of simulating the battery pack of claim 1, wherein the ECM of the battery cells is a second-order Thevenin's model including a series resistor first and second parallel resistors, and first and second parallel capacitors.

6. The method of simulating the battery pack of claim 1, wherein the battery pack includes m battery banks that are serially connected with each other,
each of the m battery banks includes n battery cells that are parallelly connected with each other,
wherein m and n are natural numbers that are greater than or equal to 1.

7. The method of simulating the battery pack of claim 6, further comprising
receiving m-1 bank resistance values between the m battery banks and a contact resistance value of each battery cell.

8. The method of simulating the battery pack of claim 7, wherein the determining of the parameter initial values of each of the battery cells, and the initial value of the G parameter and the initial value of the H parameter of the battery pack includes:
receiving an initial value of the state parameter of each battery cell;
based on the initial value of the state parameter of each battery cell, determining initial values of the ECM parameter of each battery cell;
based on the initial values of the ECM parameter of each battery cell, determining an initial value of the G parameter and an initial value of the H parameter of each battery cell; and
based on the initial value of the G parameter and the initial value of the H parameter, and the contact resistance value of each battery cell, determining an initial value of a G parameter and an initial value of an H parameter of each of the battery banks; and
based on the initial value of the G parameter and the initial value of the H parameter of each battery bank, and the m-1 bank resistance values, determining the initial value of the G parameter and the initial value of the H parameter of the battery pack.

9. The method of simulating the battery pack of claim 7, wherein the memory (120) stores a look-up table in which values of the ECM parameter based on the value of the state parameter of each battery cell are defined, and
the value of the ECM parameter of each battery cell is determined based on the look-up table and the value of the state parameter of each battery cell.

10. The method of simulating the battery pack of claim 7, wherein the value of the ECM parameter of each battery cell includes an open circuit voltage value, a series resistance value, first and second parallel resistance values, and first and second parallel capacitance values,
the value of the G parameter of each battery cell is determined to be the series resistance value of each battery cell, and
the value of the H parameter of each battery cell is determined based on the open circuit voltage value, a first voltage value, and a second voltage value of each battery cell,
wherein the first voltage value is a voltage value of a first parallel resistor and a first parallel capacitor that are parallelly connected with each other, and
the second voltage value is a voltage value of a second parallel resistor and a second parallel capacitor that are parallelly connected with each other.

11. The method of simulating the battery pack of claim 7, wherein the determining of the value of the G parameter and the value of the H parameter of the battery pack, based on the value of the G parameter and the value of the H parameter of each battery cell, includes,
based on the value of the G parameter, the value of the H parameter, and the contact resistance value of each battery cell, determining a value of a G parameter and a value of an H parameter of each battery bank; and,
based on the value of the G parameter and the value of the H parameter of each battery bank and the m-1 bank resistance values, determining the value of the G parameter and the value of the H parameter of the battery pack.

12. The method of simulating the battery pack of claim 11, wherein the value of the G parameter and the value of the H parameter of each battery bank are determined by the following equations: $G_bank \left(i\right) = \frac{1}{{\sum }_{j = 1}^{n} \frac{1}{G_cell \left(i, j\right) + R_cnt \left(i, j\right)}}$ $H_bank \left(i\right) = \frac{{\sum }_{j = 1}^{n} \frac{H_cell \left(i, j\right)}{G_cell \left(i, j\right) + R_cnt \left(i, j\right)}}{{\sum }_{j = 1}^{n} \frac{1}{G_cell \left(i, j\right) + R_cnt \left(i, j\right)}}$
where i is a natural number that is greater than or equal to 1 and less than or equal to m, and j is a natural number that is greater than or equal to 1 and less than or equal to n,
G_bank (i) is a value of a G parameter of an i^{th} battery bank from among the m battery banks (BANK),
H_bank (i) is a value of an H parameter of the i^{th} battery bank from among the m battery banks (BANK),
G_cell (i, j) is a value of a G parameter of a j^{th} battery cell from among the n battery cells included in the i^{th} battery bank,
H_cell (i, j) is a value of an H parameter of the j^{th} battery cell from among the n battery cells included in the i^{th} battery bank, and
R_cnt (i, j) is a contact resistance value of the j^{th} battery cell of the i^{th} battery bank.

13. The method of simulating the battery pack of claim 12, wherein the value of the G parameter and the value of the H parameter of the battery pack are determined by the following equations: $G_pack = {\sum }_{i = 1}^{m} G_bank \left(i\right) + {\sum }_{i = 1}^{m - 1} R_b \left(i\right)$ $H_pack = {\sum }_{i = 1}^{m} H_bank \left(i\right)$
where G_pack is the value of the G parameter of the battery pack,
H_pack is the value of the H parameter of the battery pack, and
R_b (i) is a bank resistance value between the i^{th} battery bank and an (i+1)^{th} battery bank.

14. The method of simulating the battery pack of claim 1, further comprising:
receiving one of a new pack current value and a new pack voltage value of the battery pack;
based on the one of the new pack current value and the new pack voltage value of the battery pack and a previously determined value of the G parameter and a previously determined value of the H parameter of the battery pack, determining the other of the new pack current value and the new pack voltage value of the battery pack
based on the new pack current value, the new pack voltage value, and a previously determined value of the G parameter and a previously determined value of the H parameter of each battery cell, determining a new cell voltage value, a new cell current value, and a new value of the state parameter of each battery cell;
based on the new value of the state parameter of each battery cell, determining a new value of the ECM parameter of each battery cell;
based on the new value of the ECM parameter of each battery cell, determining a new value of the G parameter and a new value of the H parameter of each battery cell; and
based on the new value of the G parameter and the new value of the H parameter of each battery cell, determining a new value of the G parameter and a new value of the H parameter of the battery pack.

## Patentansprüche

1. Verfahren zum Simulieren eines Batteriepacks, das durch eine Rechenvorrichtung (100) durchgeführt wird, die einen Prozessor (110) und einen Speicher (120) einschließt, wobei das Verfahren umfasst:
Auswählen einer Verbindungsbeziehung von Batteriezellen, die in dem Batteriepack eingeschlossen sind, und eines Ersatzschaltbildmodells, ECM, der Batteriezellen;
Bestimmen von Anfangswerten der Parameter jeder der Batteriezellen sowie eines Anfangswerts eines G-Parameters und eines Anfangswerts eines H-Parameters des Batteriepacks;
Empfangen von einem eines Pack-Stromwerts und eines Pack-Spannungswerts des Batteriepacks;
auf dem einen des Pack-Stromwerts und des Pack-Spannungswerts sowie auf dem Anfangswert des G-Parameters und des Anfangswerts des H-Parameters des Batteriepacks basierendes Bestimmen des anderen des Pack-Stromwerts und des Pack-Spannungswerts des Batteriepacks;
auf dem Pack-Stromwert und dem Pack-Spannungswert des Batteriepacks sowie auf den Anfangswerten der Parameter jeder Batteriezelle basierendes Bestimmen eines Zellenspannungswerts, eines Zellenstromwerts und eines Werts eines Zustandsparameters jeder Batteriezelle;
auf dem Wert des Zustandsparameters jeder Batteriezelle basierendes Bestimmen eines Werts eines ECM-Parameters jeder Batteriezelle;
auf dem Wert des ECM-Parameters jeder Batteriezelle basierendes Bestimmen eines Werts eines G-Parameters und eines Werts eines H-Parameters jeder Batteriezelle; und
auf dem Wert des G-Parameters und dem Wert des H-Parameters jeder Batteriezelle basierendes Bestimmen eines Werts des G-Parameters und eines Werts des H-Parameters des Batteriepacks,
wobei der G-Parameter ein Parameter ist, der einen Grad der Empfindlichkeit der Spannung in Bezug auf eine Änderung des Stroms des Batteriepacks oder der Batteriezelle angibt, und
der H-Parameter ein Parameter ist, der ein gültiges Potential angibt, das durch die lokale Gleichgewichtspotentialverteilung und die Widerstandsverteilung im Batteriepack oder in der Batteriezelle bestimmt wird.

2. Verfahren zum Simulieren des Batteriepacks nach Anspruch 1, wobei das Bestimmen der Anfangswerte der Parameter jeder der Batteriezellen sowie des Anfangswerts des G-Parameters und des Anfangswerts des H-Parameters des Batteriepacks einschließt:
Empfangen eines Anfangswerts des Zustandsparameters jeder Batteriezelle;
auf dem Anfangswert des Zustandsparameters jeder Batteriezelle basierendes Bestimmen von Anfangswerten des ECM-Parameters jeder Batteriezelle;
auf den Anfangswerten des ECM-Parameters jeder Batteriezelle basierendes Bestimmen eines Anfangswerts des G-Parameters und eines Anfangswerts des H-Parameters jeder Batteriezelle; und
auf dem Anfangswert des G-Parameters und dem Anfangswert des H-Parameters jeder Batteriezelle basierendes Bestimmen des Anfangswerts des G-Parameters und des Anfangswerts des H-Parameters des Batteriepacks.

3. Verfahren zum Simulieren des Batteriepacks nach Anspruch 1, wobei der Zustandsparameter jeder Batteriezelle einen Zellen-Ladezustand, SOC, jeder Batteriezelle einschließt.

4. Verfahren zum Simulieren des Batteriepacks nach Anspruch 1, wobei der Zustandsparameter jeder Batteriezelle ferner eine Temperatur jeder Batteriezelle einschließt.

5. Verfahren zum Simulieren des Batteriepacks nach Anspruch 1, wobei das ECM der Batteriezellen ein Thevenin-Modell zweiter Ordnung einschließt, das einen Serienwiderstand, einen ersten und einen zweiten Parallelwiderstand sowie einen ersten und einen zweiten Parallelkondensator einschließt.

6. Verfahren zum Simulieren des Batteriepacks nach Anspruch 1, wobei das Batteriepack m Batteriebänke einschließt, die miteinander in Reihe geschaltet sind,
jede der m Batteriebänke n Batteriezellen einschließt, die miteinander parallel geschaltet sind,
wobei m und n natürliche Zahlen sind, die größer oder gleich 1 sind.

7. Verfahren zum Simulieren des Batteriepacks nach Anspruch 6, ferner umfassend:
Empfangen von m-1 Bankwiderstandswerten zwischen den m Batteriebänken sowie eines Kontaktwiderstandswerts jeder Batteriezelle.

8. Verfahren zum Simulieren des Batteriepacks nach Anspruch 7, wobei das Bestimmen der Anfangswerte der Parameter jeder der Batteriezellen sowie der Anfangswerte des G-Parameters und des Anfangswerts des H-Parameters des Batteriepacks einschließt:
Empfangen eines Anfangswerts des Zustandsparameters jeder Batteriezelle;
auf dem Anfangswert des Zustandsparameters jeder Batteriezelle basierendes Bestimmen von Anfangswerten des ECM-Parameters jeder Batteriezelle;
auf den Anfangswerten des ECM-Parameters jeder Batteriezelle basierendes Bestimmen eines Anfangswerts des G-Parameters und eines Anfangswerts des H-Parameters jeder Batteriezelle; und
auf dem Anfangswert des G-Parameters und dem Anfangswert des H-Parameters sowie auf dem Kontaktwiderstandswert jeder Batteriezelle basierendes Bestimmen eines Anfangswerts eines G-Parameters und eines Anfangswerts eines H-Parameters jeder der Batteriebänke; und
auf dem Anfangswert des G-Parameters und dem Anfangswert des H-Parameters jeder Batteriebank sowie auf den m-1 Bankwiderstandswerten basierendes Bestimmen des Anfangswerts des G-Parameters und des Anfangswerts des H-Parameters des Batteriepacks.

9. Verfahren zum Simulieren des Batteriepacks nach Anspruch 7, wobei der Speicher (120) eine Nachschlagtabelle speichert, in der Werte des ECM-Parameters auf der Grundlage des Werts des Zustandsparameters jeder Batteriezelle definiert sind, und
der Wert des ECM-Parameters jeder Batteriezelle auf der Grundlage der Nachschlagtabelle und des Werts des Zustandsparameters jeder Batteriezelle bestimmt wird.

10. Verfahren zum Simulieren des Batteriepacks nach Anspruch 7, wobei der Wert des ECM-Parameters jeder Batteriezelle einen Leerlaufspannungswert, einen Serienwiderstandswert, einen ersten und einen zweiten Parallelwiderstandswert sowie einen ersten und einen zweiten Parallelkapazitätswert einschließt,
wobei der Wert des G-Parameters jeder Batteriezelle als der Serienwiderstandswert jeder Batteriezelle bestimmt wird, und
der Wert des H-Parameters jeder Batteriezelle auf der Grundlage des Leerlaufspannungswerts, eines ersten Spannungswerts und eines zweiten Spannungswerts jeder Batteriezelle bestimmt wird,
wobei der erste Spannungswert ein Spannungswert eines ersten Parallelwiderstands und eines ersten Parallelkondensators ist, die parallel zueinander geschaltet sind, und
der zweite Spannungswert ein Spannungswert eines zweiten Parallelwiderstands und eines zweiten Parallelkondensators ist, die parallel zueinander geschaltet sind.

11. Verfahren zum Simulieren des Batteriepacks nach Anspruch 7, wobei das auf dem Wert des G-Parameters und dem Wert des H-Parameters jeder Batteriezelle basierende Bestimmen des Werts des G-Parameters und des Werts des H-Parameters des Batteriepacks einschließt:
auf dem Wert des G-Parameters, dem Wert des H-Parameters und dem Kontaktwiderstandswert jeder Batteriezelle basierendes Bestimmen eines Werts eines G-Parameters und eines Werts eines H-Parameters jeder Batteriebank; und
auf dem Wert des G-Parameters und dem Wert des H-Parameters jeder Batteriebank sowie auf den m-1 Bankwiderstandswerten basierendes Bestimmen des Werts des G-Parameters und des Werts des H-Parameters des Batteriepacks.

12. Verfahren zum Simulieren des Batteriepacks nach Anspruch 11, wobei der Wert des G-Parameters und der Wert des H-Parameters jeder Batteriebank durch die folgenden Gleichungen bestimmt werden: $G_bank \left(i\right) = \frac{1}{{\sum }_{j = 1}^{n} \frac{1}{G_cell \left(i, j\right) + R_cnt \left(i, j\right)}}$ $H_bank \left(i\right) = \frac{{\sum }_{j = 1}^{n} \frac{H_cell \left(i, j\right)}{G_cell \left(i, j\right) + R_cnt \left(i, j\right)}}{{\sum }_{j = 1}^{n} \frac{1}{G_cell \left(i, j\right) + R_cnt \left(i, j\right)}}$
wobei i eine natürliche Zahl ist, die größer oder gleich 1 und kleiner oder gleich m ist, und j eine natürliche Zahl ist, die größer oder gleich 1 und kleiner oder gleich n ist,
G_bank(i) ein Wert eines G-Parameters einer i^{-ten} Batteriebank unter den m Batteriebänken (BANK) ist,
H_bank(i) ein Wert eines H-Parameters der i^{-ten} Batteriebank unter den m Batteriebänken (BANK) ist,
G_cell(i, j) ein Wert eines G-Parameters einer j^{-ten} Batteriezelle unter den n Batteriezellen, die in der i^{-ten} Batteriebank eingeschlossen sind, ist,
H_cell(i, j) ein Wert eines H-Parameters der j^{-ten} Batteriezelle unter den n Batteriezellen, die in der i^{-ten} Batteriebank eingeschlossen sind, ist, und
R_cnt(i, j) ein Kontaktwiderstandswert der j^{-ten} Batteriezelle der i^{-ten} Batteriebank ist.

13. Verfahren zum Simulieren des Batteriepacks nach Anspruch 12, wobei der Wert des G-Parameters und der Wert des H-Parameters des Batteriepacks durch die folgenden Gleichungen bestimmt werden: $G_pack = {\sum }_{i = 1}^{m} G _bank \left(i\right) + {\sum }_{i = 1}^{m - 1} R_b \left(i\right)$ $H_pack = {\sum }_{i = 1}^{m} H_bank \left(i\right)$
wobei G_pack der Wert des G-Parameters des Batteriepacks ist,
H_pack der Wert des H-Parameters des Batteriepacks ist, und
R_b(i) ein Bankwiderstandswert zwischen der i^{-ten} Batteriebank und einer (i+1)^{-ten} Batteriebank ist.

14. Verfahren zum Simulieren des Batteriepacks nach Anspruch 1, ferner umfassend:
Empfangen von einem eines neuen Pack-Stromwerts und eines neuen Pack-Spannungswerts des Batteriepacks;
auf dem einen des neuen Pack-Stromwerts und des neuen Pack-Spannungswerts des Batteriepacks sowie auf einem zuvor ermittelten Wert des G-Parameters und einem zuvor ermittelten Wert des H-Parameters des Batteriepacks basierendes Bestimmen des anderen des neuen Pack-Stromwerts und des neuen Pack-Stromwerts des Batteriepacks;
auf dem neuen Pack-Stromwert, dem neuen Pack-Spannungswert sowie auf einem zuvor ermittelten Wert des G-Parameters und einem zuvor ermittelten Wert des H-Parameters jeder Batteriezelle basierendes Bestimmen eines neuen Zellenspannungswerts, eines neuen Zellenstromwerts und eines neuen Werts des Zustandsparameters jeder Batteriezelle;
auf dem neuen Wert des Zustandsparameters jeder Batteriezelle basierendes Bestimmen eines neuen Werts des ECM-Parameters jeder Batteriezelle;
auf dem neuen Wert des ECM-Parameters jeder Batteriezelle basierendes Bestimmen eines neuen Werts des G-Parameters und eines neuen Werts des H-Parameters jeder Batteriezelle; und
auf dem neuen Wert des G-Parameters und dem neuen Wert des H-Parameters jeder Batteriezelle basierendes Bestimmen eines neuen Werts des G-Parameters und eines neuen Werts des H-Parameters des Batteriepacks.

## Revendications

1. Procédé de simulation d'un bloc-batterie, réalisé par un dispositif informatique (100) incluant un processeur (110) et une mémoire (120), le procédé comprenant :
la sélection d'une relation de connexion des cellules de batterie incluses dans le bloc-batterie et d'un modèle de circuit équivalent, ECM, des cellules de batterie ;
la détermination de valeurs initiales de paramètres de chacune des cellules de batterie, et d'une valeur initiale d'un paramètre G et d'une valeur initiale d'un paramètre H du bloc-batterie ;
la réception d'une parmi une valeur de courant de bloc et une valeur de tension de bloc du bloc-batterie ;
sur la base d'une parmi la valeur de courant de bloc et la valeur de tension de bloc et la valeur initiale du paramètre G et la valeur initiale du paramètre H du bloc-batterie, la détermination de l'autre parmi la valeur de courant de bloc et la valeur de tension de bloc du bloc-batterie ;
sur la base de la valeur de courant de bloc et de la valeur de tension de bloc du bloc-batterie et des valeurs initiales de paramètres de chaque cellule de batterie, la détermination d'une valeur de tension de cellule, d'une valeur de courant de cellule et d'une valeur d'un paramètre d'état de chaque cellule de batterie ;
sur la base de la valeur du paramètre d'état de chaque cellule de batterie, la détermination d'une valeur d'un paramètre ECM de chaque cellule de batterie ;
sur la base de la valeur du paramètre ECM de chaque cellule de batterie, la détermination d'une valeur d'un paramètre G et d'une valeur d'un paramètre H de chaque cellule de batterie ; et
sur la base de la valeur du paramètre G et de la valeur du paramètre H de chaque cellule de batterie, la détermination d'une valeur du paramètre G et d'une valeur du paramètre H de la cellule de batterie,
dans lequel le paramètre G est un paramètre indiquant un degré de sensibilité de tension par rapport à une variation de courant du bloc-batterie ou de la cellule de batterie, et
le paramètre H est un paramètre indiquant un potentiel valide déterminé par une distribution de potentiel et une distribution de résistance d'équilibre local dans le bloc-batterie ou dans la cellule de batterie.

2. Procédé de simulation du bloc-batterie selon la revendication 1, dans lequel la détermination des valeurs initiales de paramètres de chaque cellule de batterie et des valeurs initiales du paramètre G et des valeurs initiales du paramètre H du bloc-batterie, inclut :
la réception d'une valeur initiale du paramètre d'état de chaque cellule de batterie ;
sur la base de la valeur initiale du paramètre d'état de chaque cellule de batterie, la détermination de valeurs initiales du paramètre ECM de chaque cellule de batterie ;
sur la base des valeurs initiales du paramètre ECM de chaque cellule de batterie, la détermination d'une valeur initiale du paramètre G et d'une valeur initiale du paramètre H de chaque cellule de batterie ; et
sur la base de la valeur initiale du paramètre G et de la valeur initiale du paramètre H de chaque cellule de batterie, la détermination de la valeur initiale du paramètre G et de la valeur initiale du paramètre H de la cellule de batterie.

3. Procédé de simulation du bloc-batterie selon la revendication 1, dans lequel le paramètre d'état de chaque cellule de batterie inclut un état de charge (SOC) de cellule de chaque cellule de batterie.

4. Procédé de simulation du bloc-batterie selon la revendication 1, dans lequel le paramètre d'état de chaque cellule de batterie inclut en outre une température de chaque cellule de batterie.

5. Procédé de simulation du bloc-batterie selon la revendication 1, dans lequel l'ECM des cellules de batterie est un modèle de Thévenin de second ordre incluant une résistance en série, des première et seconde résistances en parallèle, et des premier et second condensateurs en parallèle.

6. Procédé de simulation du bloc-batterie selon la revendication 1, dans lequel le bloc-batterie inclut m bancs de batterie connectés en série les uns aux autres,
chacun des m bancs de batterie inclut n cellules de batterie connectées en parallèle les unes aux autres,
dans lequel m et n sont des nombres naturels supérieurs ou égaux à 1.

7. Procédé de simulation du bloc-batterie selon la revendication 6, comprenant en outre
la réception de valeurs de résistance de banc m-1 entre les bancs de batterie m et une valeur de résistance de contact de chaque cellule de batterie.

8. Procédé de simulation du bloc-batterie selon la revendication 7, dans lequel la détermination des valeurs initiales de paramètres de chaque cellule de batterie et des valeurs initiales du paramètre G et des valeurs initiales du paramètre H du bloc-batterie, inclut :
la réception d'une valeur initiale du paramètre d'état de chaque cellule de batterie ;
sur la base de la valeur initiale du paramètre d'état de chaque cellule de batterie, la détermination de valeurs initiales du paramètre ECM de chaque cellule de batterie ;
sur la base des valeurs initiales du paramètre ECM de chaque cellule de batterie, la détermination d'une valeur initiale du paramètre G et d'une valeur initiale du paramètre H de chaque cellule de batterie ; et
sur la base de la valeur initiale du paramètre G et de la valeur initiale du paramètre H et de la valeur de résistance de contact de chaque cellule de batterie, la détermination d'une valeur initiale d'un paramètre G et d'une valeur initiale d'un paramètre H de chacun des bancs de batterie ; et
sur la base de la valeur initiale du paramètre G et de la valeur initiale du paramètre H de chaque banc de batterie, et des valeurs de résistance de banc m-1, la détermination de la valeur initiale du paramètre G et de la valeur initiale du paramètre H de la cellule de batterie.

9. Procédé de simulation du bloc-batterie selon la revendication 7, dans lequel la mémoire (120) stocke une table de consultation dans laquelle sont définies les valeurs du paramètre ECM sur la base de la valeur du paramètre d'état de chaque cellule de batterie, et
la valeur du paramètre ECM de chaque cellule de batterie est déterminée sur la base de la table de consultation et de la valeur du paramètre d'état de chaque cellule de batterie.

10. Procédé de simulation du bloc-batterie selon la revendication 7, dans lequel la valeur du paramètre ECM de chaque cellule de batterie inclut une valeur de tension en circuit ouvert, une valeur de résistance en série, des première et seconde valeurs de résistance en parallèle, et des première et seconde valeurs de capacité en parallèle,
la valeur du paramètre G de chaque cellule de batterie est déterminée comme étant la valeur de résistance en série de chaque cellule de batterie, et
la valeur du paramètre H de chaque cellule de batterie est déterminée sur la base de la valeur de tension en circuit ouvert, d'une première valeur de tension et d'une seconde valeur de tension de chaque cellule de batterie,
dans lequel la première valeur de tension est la valeur de tension d'une première résistance et d'un premier condensateur en parallèle, connectés en parallèle l'un à l'autre, et
la seconde valeur de tension est une valeur de tension d'une seconde résistance parallèle et d'un second condensateur parallèle connectés en parallèle l'un à l'autre.

11. Procédé de simulation du bloc-batterie selon la revendication 7, dans lequel la détermination de la valeur du paramètre G et de la valeur du paramètre H du bloc-batterie, sur la base de la valeur du paramètre G et de la valeur du paramètre H de chaque cellule de batterie, inclut :
sur la base de la valeur du paramètre G, de la valeur du paramètre H et de la valeur de résistance de contact de chaque cellule de batterie, la détermination d'une valeur d'un paramètre G et d'une valeur d'un paramètre H de chaque banc de batterie ; et,
sur la base de la valeur du paramètre G et de la valeur du paramètre H de chaque banc de batterie, et des valeurs de résistance de banc m-1, la détermination de la valeur du paramètre G et de la valeur du paramètre H de la cellule de batterie.

12. Procédé de simulation du bloc-batterie selon la revendication 11, dans lequel la valeur du paramètre G et la valeur du paramètre H de chaque banc de batterie sont déterminées par les équations suivantes : $G_bank \left(i\right) = \frac{1}{{\sum }_{j = 1}^{n} \frac{1}{G_cell \left(i, j\right) + R_cnt \left(i, j\right)}}$ $H_bank \left(i\right) = \frac{{\sum }_{j = 1}^{n} \frac{H_cell \left(i, j\right)}{G_cell \left(i, j\right) + R_cnt \left(i, j\right)}}{{\sum }_{j = 1}^{n} \frac{1}{G_cell \left(i, j\right) + R_cnt \left(i, j\right)}}$
où i est un nombre naturel supérieur ou égal à 1 et inférieur ou égal à m, et j est un nombre naturel supérieur ou égal à 1 et inférieur ou égal à n,
G_bank (i) est une valeur d'un paramètre G d'un i^{ème} banc de batterie parmi les m bancs de batterie (BANK),
H_bank (i) est une valeur d'un paramètre H de l'i^{ème} banc de batterie parmi les m bancs de batterie (BANK),
G_cell (i, j) est une valeur d'un paramètre G de la j^{ème} cellule de batterie parmi les n cellules de batterie incluses dans l'i^{ème} banc de batterie,
H_cell (i, j) est une valeur d'un paramètre H de la j^{-ième} cellule de batterie parmi les n cellules de batterie incluses dans l'i^{ème} banc de batterie, et
R_cnt (i, j) est une valeur de résistance de contact de la j^{ème} cellule de batterie de l'i^{ème} banc de batterie.

13. Procédé de simulation du bloc-batterie selon la revendication 12, dans lequel la valeur du paramètre G et la valeur du paramètre H du bloc-batterie sont déterminées par les équations suivantes : $G_pack = {\sum }_{i = 1}^{m} G _bank \left(i\right) + {\sum }_{i = 1}^{m - 1} R_b \left(i\right)$ $H_pack = {\sum }_{i = 1}^{m} H_bank \left(i\right)$
où G_pack est la valeur du paramètre G du bloc-batterie,
H_pack est la valeur du paramètre H du bloc-batterie, et
R_b (i) est la valeur de résistance de banc entre l'i ^{ème} banc de batterie et un (i+1) ^{ème} banc de batterie.

14. Procédé de simulation du bloc-batterie selon la revendication 1, comprenant en outre :
la réception d'une parmi une nouvelle valeur de courant de bloc et une nouvelle valeur de tension de bloc du bloc-batterie ;
sur la base d'une parmi la nouvelle valeur de courant de bloc et la nouvelle valeur de tension de bloc du bloc-batterie et une valeur précédemment déterminée du paramètre G et une valeur précédemment déterminée du paramètre H du bloc-batterie, la détermination de l'autre parmi la nouvelle valeur de courant de bloc et la nouvelle valeur de tension de bloc du bloc-batterie ;
sur la base de la nouvelle valeur de courant de bloc, de la nouvelle valeur de tension de bloc, et d'une valeur précédemment déterminée du paramètre G et d'une valeur précédemment déterminée du paramètre H de chaque cellule de batterie, la détermination d'une nouvelle valeur de tension de cellule, d'une nouvelle valeur de courant de cellule et d'une nouvelle valeur du paramètre d'état de chaque cellule de batterie ;
sur la base de la nouvelle valeur du paramètre d'état de chaque cellule de batterie, la détermination d'une nouvelle valeur du paramètre ECM de chaque cellule de batterie ;
sur la base de la nouvelle valeur du paramètre ECM de chaque cellule de batterie, la détermination d'une nouvelle valeur du paramètre G et d'une nouvelle valeur du paramètre H de chaque cellule de batterie ; et
sur la base de la nouvelle valeur du paramètre G et de la nouvelle valeur du paramètre H de chaque cellule de batterie, la détermination d'une nouvelle valeur du paramètre G et d'une nouvelle valeur du paramètre H de la cellule de batterie.
